# EUROPÄISCHE PATENTSCHRIFT

(11) **EP 2 341 534 B1**
(45) Veröffentlichungstag und Bekanntmachung des Hinweises auf die Patenterteilung: **07.05.2014**
(21) Anmeldenummer: 10192550.1
(22) Anmeldetag: 25.11.2010
(51) Int. Cl.: H01L 25/07, H01L 23/00, H01R 13/24

(54) **Leistungshalbleitermodul**
Power semiconductor module
Module semi-conducteur de puissance

(30) Priorität: 05.01.2010 DE 102010000694
(43) Veröffentlichungstag der Anmeldung: 06.07.2011
(73) Patentinhaber: SEMIKRON Elektronik GmbH & Co. KG, 90431 Nürnberg (DE)
(72) Erfinder: Popp, Rainer, 91580, Petersaurach (DE); Frank, Thomas, 91207, Lauf (DE)

(56) Entgegenhaltungen:
- DE-A1-102006 006 421
- DE-B3-102006 034 964
- JP-A- 2006 164 660

## Beschreibung

Die Erfindung betrifft ein Leistungshalbleitermodul nach dem Oberbegriff des Patentanspruchs 1.

Ein solches Leistungshalbleitermodul ist z. B. aus der DE 10 2006 006 425 B4 bekannt. - Dabei ist eine Druckkontaktfeder in einem Führungskanal geführt, welcher einen runden Querschnitt aufweist. Der Führungskanal ist Bestandteil eines aus einem Kunststoff hergestellten Gehäuses oder eines Gehäusebestandteils. In jüngerer Zeit ist man in der Praxis dazu übergegangen, das Gehäuse aus Polyamid herzustellen. Die Verwendung von Polyamid ist im Hinblick auf verschiedene Belange von Vorteil. Bei langen Standzeiten wird allerdings mitunter eine Korrosion der Druckkontaktfedern beobachtet.

Aus der DE 20 2006 006 421 A1 ist ein Leistungshalbleitermodul mit mindestens einem Substrat, mindestens einem hierauf angeordnete Leistungshalbleiterbauelement, einem Gehäuse, einem ersten Kunststoffformkörper, nach außen führenden Anschlusselementen und einem zweiten Kunststoffformkörper, wobei das Substrat einen Isolierstoffkörper aufweist und auf dessen erster dem Inneren des Leistungshalbleitermoduls zugewandten Hauptfläche Leiterbahnen angeordnet sind, bekannt.

Aus der JP2006164660 A ist eine Hülse mit einem zum Teil im Inneren der Hülse anordneten Bolzen und eine im Inneren der Hülse angeordnete Feder bekannt.

Aufgabe der Erfindung ist es, die Nachteile nach dem Stand der Technik zu beseitigen. Es soll insbesondere ein Leistungshalbleitermodul angegeben werden, bei dem in einfacher und kostengünstiger Weise einer Korrosion der Druckkontaktfedern entgegengewirkt wird.

Diese Aufgabe wird durch die Merkmale des Anspruchs 1 gelöst. Zweckmäßige Ausgestaltungen der Erfindung ergeben sich aus den Merkmalen der Ansprüche 2 bis 7.

Nach Maßgabe der Erfindung ist vorgesehen, dass der Führungskanal an seinem Innenumfang in Führungsrichtung sich erstreckende Vorsprünge aufweist. Durch das Vorsehen der Vorsprünge wird eine Kontaktfläche zwischen der Druckkontaktfeder und dem Gehäuse erheblich vermindert. Es hat sich überraschenderweise herausgestellt, dass durch diese einfache Maßnahme einer anscheinend durch einen Kontakt der Druckkontaktfeder mit dem Gehäuse bedingten Korrosion der Druckkontaktfeder entgegengewirkt werden kann. Die vorgeschlagene Maßnahme lässt sich einfach und kostengünstig ausführen. Es ist insbesondere keine aufwendige Korrosionsschutzbeschichtung am Innenumfang des Führungskanals und/oder an der Oberfläche der Druckkontaktfedern erforderlich.

Nach einer weiteren Ausgestaltung ist vorgesehen, dass der Führungskanal zumindest einen in Führungsrichtung sich erstreckenden schlitzartigen Durchbruch aufweist. Auch durch das Vorsehen eines Durchbruchs kann ein unerwünschter Kontakt zwischen der Druckkontaktfeder und dem Gehäuse vermieden werden. Abgesehen davon kann durch das Vorsehen des vorgeschlagenen schlitzartigen Durchbruchs Material eingespart und eine einer Korrosion entgegenwirkende Belüftung des Führungskanals erreicht werden.

Am Innenumfang sind zumindest drei Vorsprünge vorgesehen. Selbstverständlich können auch vier oder mehr Vorsprünge am Innenumfang vorgesehen sein. Die Vorsprünge sind zweckmäßigerweise im selben Winkel voneinander beabstandet.

Nach einer weiteren Ausgestaltung kann der Führungskanal einen großen und einen kleinen Innendurchmesser aufweisen. In diesem Fall können sich die Vorsprünge lediglich entlang eines den großen Durchmesser aufweisenden ersten Abschnitts des Führungskanals erstrecken. Im ersten Abschnitt des Führungskanals ist die Druckkontaktfeder mit ihrem spiralförmigen ersten Federabschnitt geführt. In einem zweiten, den kleinen Durchmesser aufweisenden Abschnitt des Führungskanals kann dagegen lediglich ein vom Ende des ersten Federabschnitts sich in Führungsrichtung erstreckender Federdraht vorgesehen sein, welcher einen zweiten Federabschnitt bildet.

Das Gehäuse kann ein Top- und ein Basisteil umfassen. Der Führungskanal kann zumindest abschnittsweise im Topteil vor-gesehen sein. Es ist aber auch möglich, dass das Gehäuse ein zwischen dem Top- und Basisteil angeordnetes Zwischenteil umfasst. In diesem Fall kann der Führungskanal zumindest abschnittsweise im Zwischenteil vorgesehen sein.

Die erste Baugruppe ist zweckmäßigerweise mit zumindest einem Leistungshalbleiter bestückt. Dabei kann der Leistungshalbleiter beispielweise auf einem DCB-Substrat montiert sein. Der erste Kontakt kann auf einer den Leistungshalbleiter tragenden Oberseite des DCB-Substrats vorgesehen sein. Bei der zweiten Baugruppe kann es sich beispielsweise um eine Steuerschaltung bzw. einen Controller handeln, an dessen Unterseite der zweite Kontakt vorgesehen ist. An einer der Unterseite gegenüberliegenden Oberseite können im Wesentlichen die die Steuerschaltung bildenden Bauelemente montiert sein.

Nachfolgend wird ein Ausführungsbeispiel der Erfindung anhand der Zeichnung näher erläutert. Es zeigen:
- Fig. 1: eine teilweise aufgebrochene perspektivische Teilansicht eines Zwischenteils und
- Fig. 2: eine Draufsicht gemäß Fig. 1.

Die Figuren zeigen einen Ausschnitt aus einem Zwischenteil eines Gehäuses zur Herstellung eines Leistungshalbleitermoduls in Druckkontakttechnik. Das allgemein mit dem Bezugszeichen 1 bezeichnete Zwischenteil ist aus einem Kunststoff, vorzugsweise aus Polyamid, hergestellt. Der Kunststoff kann mit Glasfasern gefüllt sein. Der Gehalt an Glasfasern kann 25 bis 35 Gew.-% betragen. Beispielsweise kann ein Kunststoff vom Typ "Ultramid A3WG6" verwenden werden.

Zur Montage des Leistungshalbleitermoduls wird das Zwischenteil 1 auf ein Basisteil montiert, in dem beispielsweise Leistungshalbleitermodule auf einem Kühlkörper abgestützt sind (hier nicht gezeigt). Auf das Zwischenteil 1 wird eine Steuerschaltungsplatine montiert (hier nicht gezeigt), so dass im Zwischenteil 1 gehaltene Druckkontaktfedern 2 elastisch verformt werden und einem Druckkontakt zwischen an einer Rückseite der Steuerschaltungsplatine vorgesehenen zweiten Kontakten (hier nicht gezeigt) und an einer Oberseite der Leistungshalbleitermodule vorgesehenen ersten Kontakten (hier nicht gezeigt) hergestellt wird.

Wie aus den Figuren ersichtlich ist, wird jede Druckkontaktfeder 2 in einem Führungskanal 3 gehalten. In der gezeigten Ausgestaltung weist der Führungskanal 3 einen ersten Abschnitt A1 mit einem großen Durchmesser Dg und einen zweiten Abschnitt A2 mit einem kleinen Durchmesser Dk auf. Zwischen dem ersten Abschnitt A1 und dem zweiten Abschnitt A2 ist ein dritter Abschnitt A3 gebildet, in dem sich der Durchmesser des Führungskanals 3 vom großen Durchmesser Dg zum kleinen Durchmesser Dk hin verjüngt.

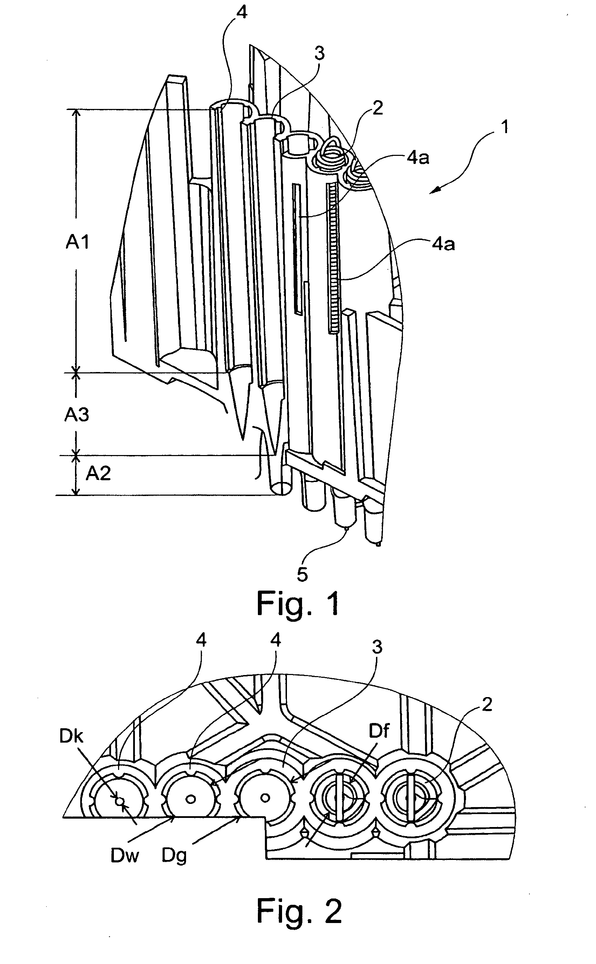

Am Innenumfang des Führungskanals 3 erstrecken sich in einer axial verlaufenen Führungsrichtung mehrere Vorsprünge 4 entlang des ersten Abschnitts A1. Die Vorsprünge 4 können ein konvexes, halbrundes oder auch spitz zulaufendes Profil aufweisen. Sie sind insbesondere so ausgebildet, dass eine Berührungsfläche zu den Druckkontaktfedern 3 möglichst klein ist. Wie aus Fig. 1 ersichtlich ist, können in einer Wand der Führungskanäle 3 auch schlitzartige Durchbrüche 4a vorgesehen sein, welche sich in die Führungsrichtung erstrecken.

Ein Durchmesser Df der Druckkontaktfedern ist kleiner als ein durch die radial inneren Punkte oder Linien der Vorsprünge 4 definierter weiterer Durchmesser Dw.

Wie insbesondere aus Fig. 2 ersichtlich ist, weist hier jeder der Führungskanäle 3 an seinem Innenumfang vier Vorsprünge 4 auf, welche jeweils in einem Winkel von 90 °C voneinander beabstandet sind. Die Vorsprünge 4 weisen radial innenliegend eine durchgehende gerade Gleitfläche auf.

Die Druckkontaktfedern 2 weisen einen ersten spiralförmigen Federabschnitt mit dem Durchmesser Df auf. Der erste Federabschnitt ist im Bereich des ersten Abschnitts A1 des Führungskanals 3 geführt. Ferner weisen die Druckkontaktfedern 2 einen sich vom ersten Federabschnitt erstreckenden zweiten Federabschnitt auf, welcher aus einem in Führungsrichtung sich erstreckenden Federdraht 5 gebildet ist. Der Federdraht 5 ist durch einen den kleinen Durchmesser Dk aufweisenden Durchgang des Führungskanals 3 geführt.

Insgesamt zeichnet sich das beschriebene Gehäuseteil, hier das Zwischenteil 1, dadurch aus, dass die Kontaktfläche zwischen dem ersten Federabschnitt der Druckkontaktfedern 2 und dem Führungskanal 3 besonders klein ist. Es kann damit eine unerwünschte Korrosion der Druckkontaktfeder 2 vermieden werden.

### Bezugszeichenliste

- 1: Zwischenteil
- 2: Druckkontaktfeder
- 3: Führungskanal
- 4: Vorsprung
- 4a: schlitzartiger Durchbruch
- 5: Federdraht
- A1: erster Abschnitt
- A2: zweiter Abschnitt
- A3: dritter Abschnitt
- Dg: großer Durchmesser
- Dk: kleiner Durchmesser
- Df: Durchmesser des ersten Federabschnitts
- Dw: weiterer Durchmesser

## Patentansprüche

1. Leistungshalbleitermodul, bei dem in einem Gehäuse zumindest ein Führungskanal (3) mit einer darin geführten Druckkontaktfeder (2) vorgesehen ist, welche in Druckkontakttechnik einen an einer ersten Baugruppe vorgesehenen ersten Kontakt mit einem an einer zweiten Baugruppe vorgesehenen zweiten Kontakt oder einem Anschlusselement elektrisch verbindet,
**dadurch gekennzeichnet, dass**
der Führungskanal (3) an seinem Innenumfang in Führungsrichtung sich erstreckende Vorsprünge (4) aufweist, wobei am Innenumfang zumindest drei Vorsprünge (4) vorgesehen sind, wobei die Vorsprünge (4) eine Berührungsfläche zu der Druckkontaktfeder (2) aufweisen.

2. Leistungshalbleitermodul nach Anspruch 1, wobei der Führungskanal (3) zumindest einen in Führungsrichtung sich erstreckenden schlitzartigen Durchbruch (4a) aufweist.

3. Leistungshalbleitermodul nach einem der vorhergehenden Ansprüche, wobei die Vorsprünge (4) im selben Winkel voneinander beabstandet sind.

4. Leistungshalbleitermodul nach einem der vorhergehenden Ansprüche, wobei der Führungskanal (3) einen großen (Dg) und einen kleinen Innendurchmesser (Dk) aufweist, und sich die Vorsprünge (4) lediglich entlang eines den großen Durchmesser (Dg) aufweisenden ersten Abschnitts (A1) des Führungskanals (3) erstrecken.

5. Leistungshalbleitermodul nach einem der vorhergehenden Ansprüche, wobei das Gehäuse ein Top- und ein Basisteil umfasst, und der Führungskanal (3) zumindest abschnittsweise im Topteil vorgesehen ist.

6. Leistungshalbleitermodul nach einem der vorhergehenden Ansprüche, wobei das Gehäuse ein zwischen dem Top- und dem Basisteil angeordnetes Zwischenteil (1) umfasst, und der Führungskanal (3) zumindest abschnittsweise im Zwischenteil (1) vorgesehen ist.

7. Leistungshalbleitermodul nach einem der vorhergehenden Ansprüche, wobei die erste Baugruppe mit zumindest einem Leistungshalbleiter bestückt ist.

## Claims

1. A power semiconductor module, in which at least one guidance channel (3). with a pressure contact spring (2) guided therein, is provided in a housing, which using pressure contact technology electrically connects a first contact provided on a first module with a second contact or terminal element provided on a second module, 1
**characterised in that**,
the guidance channel (3) has projections (4) extending in the direction of guidance on its inner periphery, wherein
at least three projections (4) are provided on the inner periphery , wherein
the projections (4) have a surface area in contact with the pressure contact spring (2).

2. The power semiconductor module in accordance with Claim 1, wherein
the guidance channel (3) has at least one slot-type aperture (4a) extending in the direction of guidance.

3. The power semiconductor module in accordance with one of the preceding claims, wherein
the projections (4) are spaced apart from one another by the same angle.

4. The power semiconductor module in accordance with one of the preceding claims, wherein
the guidance channel (3) has a large inner diameter (Dg) and a small inner diameter (Dk), and the projections (4) extend along just a first section (A1) of the guidance channel having the large diameter (Dg).

5. The power semiconductor module in accordance with one of the preceding claims, wherein
the housing features a top part and a base part, and at least some sections of the guidance channel (3) are provided in the top part.

6. The power semiconductor module in accordance with one of the preceding claims, wherein
the housing features an intermediate part (1) arranged between the top part and the base part, and at least some sections of the guidance channel (3) are provided in the intermediate part (1).

7. The power semiconductor module in accordance with one of the preceding claims, wherein
the first module is populated with at least one power semiconductor.

## Revendications

1. Module semi-conducteur de puissance, au moins un canal de guidage (3) étant prévu, dans un boîtier, avec un ressort de contact par pression (2) guidé à l'intérieur de celui-ci, lequel relie électriquement par technique de contact par pression un premier contact prévu sur un premier groupe de composants à un deuxième contact prévu sur un deuxième groupe de composants ou à un élément de connexion,
**caractérisé en ce que** :
le canal de guidage (3) présente sur son pourtour intérieur des saillies (4) s'étendant dans la direction de guidage, au moins trois saillies (4) étant prévues sur le pourtour intérieur, lesdites saillies (4) présentant une surface de contact avec le ressort de contact par pression (2).

2. Module semi-conducteur de puissance selon la revendication 1, dans lequel le canal de guidage (3) présente au moins une ouverture (4a) en forme de fente s'étendant dans la direction de guidage.

3. Module semi-conducteur de puissance selon l'une des revendications précédentes, dans lequel les saillies (4) sont espacées l'une de l'autre suivant le même angle.

4. Module semi-conducteur de puissance selon l'une des revendications précédentes, dans lequel le canal de guidage (3) présente un grand diamètre intérieur (Dg) et un petit diamètre intérieur (Dk), et les saillies (4) ne s'étendent que le long d'un premier tronçon (A1) du canal de guidage (3) ayant le grand diamètre (Dg).

5. Module semi-conducteur de puissance selon l'une des revendications précédentes, dans lequel le boîtier comprend une pièce de sommet et une pièce de base, et le canal de guidage (3) est au moins partiellement prévu dans la pièce de sommet.

6. Module semi-conducteur de puissance selon l'une des revendications précédentes, dans lequel le boîtier comprend une pièce intermédiaire (1) entre la pièce de sommet et la pièce de base, et le canal de guidage (3) est au moins partiellement prévu dans la pièce intermédiaire (1).

7. Module semi-conducteur de puissance selon l'une des revendications précédentes, dans lequel le premier groupe de composants est équipé d'au moins un semi-conducteur de puissance.
